# EUROPEAN PATENT APPLICATION

(11) **EP 4 811 951 A1**
(43) Date of publication of application: **23.09.2026**
(21) Application number: 24891368.3
(22) Date of filing: 11.11.2024
(51) Int. Cl.: H05K 9/00, B32B 7/025, H01Q 17/00

(54) **ELECTROMAGNETIC-WAVE ABSORBING SHEET**

(30) Priority: 14.11.2023 JP 2023193654
(71) Applicant: Maxell, Ltd., Kyoto 618-8525 (JP); INSTITUTE OF SCIENCE TOKYO, Tokyo 152-8550 (JP)
(72) Inventor: KISHIMI Yuko, Kyoto 618-8525 (JP); KITO Akiko, Kyoto 618-8525 (JP); MIZUTANI Takuo, Kyoto 618-8525 (JP); DOBATA Miyuki, Kyoto 618-8525 (JP); LEE Sangyeop, Tokyo 152-8550 (JP)
(74) Representative: Mewburn Ellis LLP
(86) International application number: PCT/JP2024/039944
(87) International publication number: WO 2025/105332

(57) **Abstract**

An electromagnetic-wave absorbing sheet is realized which has a plurality of electromagnetic-wave absorption bands in a high frequency band from several hundred GHz to the terahertz band, and each of the electromagnetic-wave absorption bands has a wide bandwidth. The electromagnetic-wave absorbing sheet includes a first dielectric layer, a resistive layer, a second dielectric layer, and a reflective layer that are sequentially laminated from an electromagnetic-wave incident side, and when a permittivity of the first dielectric layer is ε1 and a thickness of the first dielectric layer is D1, and a permittivity of the second dielectric layer is ε2 and a thickness of the second dielectric layer is D2, the following (Equation 1) and (Equation 2) are satisfied with respect to a center wavelength λ of electromagnetic waves. $D 1 = 5 λ / 4 √ ε 1 \pm 20 %$$D 2 = 5 λ / 4 √ ε 2 \pm 20 %$

## Description

### Technical Field

The present disclosure relates to an electromagnetic-wave absorbing sheet that absorbs unwanted electromagnetic waves, and in particular to an electromagnetic-wave absorbing sheet that absorbs electromagnetic waves in a plurality of frequency bands in high frequency bands greater than or equal to the millimeter wave band.

### Background Art

In recent years, there has been increasing use of electromagnetic waves in high frequency bands, such as centimeter waves in a frequency band of several gigahertz (GHz), and even millimeter waves in a frequency band of 30 to 300 gigahertz, for mobile communication of mobile phones and the like, wireless LAN, electronic toll collection systems (ETC), and the like. In addition, accompanying the ever-evolving communication environment, the rise of IoT, and the like, there is demand for the development of devices for Beyond 5G and 6G communication, and research into technologies that utilize electric waves having frequencies in the terahertz (THz (1 THz = 1000 GHz)) band is also progressing.

As the frequency of the electromagnetic waves used increases, specific materials that can handle high-frequency electromagnetic waves are required for transmission and reception systems such as antenna circuits, testing equipment devices, and also for noise countermeasures for these devices, prevention of electromagnetic-wave leakage, and the like. In particular, in devices that handle electromagnetic waves in the terahertz band, location dependency cannot be ignored for all materials used, such as conductors within circuits, circuit boards, and exterior members, and strict adjustment and design of length, size, and thickness are required.

Conventionally, an electromagnetic-wave absorbing sheet that absorbs electromagnetic waves of a plurality of frequencies in the millimeter wave band has been proposed which includes an electromagnetic-wave absorbing layer formed by laminating, on a front side of a reflective layer, a plurality of magnetic layers in which magnetic iron oxide, which generates magnetic resonance with electromagnetic waves in the millimeter-wave band and absorbs the electromagnetic waves, is dispersed in a dielectric binder (Patent Document 1).

### Prior Art Documents

### Patent Documents

[Patent Document 1] JP 2022-84611A

### Disclosure of Invention

### Problem to be Solved by the Invention

The above-mentioned conventional electromagnetic-wave absorbing sheet can effectively absorb electromagnetic waves of different frequencies in the millimeter-wave band by utilizing the different magnetic resonance frequencies of the magnetic iron oxide contained in the magnetic layers.

However, according to the description of the examples, although the frequency characteristic of the electromagnetic waves absorbed by the above-mentioned conventional electromagnetic-wave absorbing sheet has five peaks at 70 GHz, 90 GHz, 120 GHz, 150 GHz, and 178 GHz, the effective electromagnetic-wave absorption amount of 10 dB (90% attenuation) can only be achieved in three bands, namely, the 120 GHz band, the 150 GHz band, and the 180 GHz band, and moreover, the width of each frequency band is less than 20 GHz, and thus the conventional electromagnetic-wave absorbing sheet cannot be said to be sufficient as an electromagnetic-wave absorbing sheet that can absorb electromagnetic waves in different frequency bands.

The present disclosure aims to solve the above-mentioned problems and to realize an electromagnetic-wave absorbing sheet that has a plurality of electromagnetic-wave absorption bands in high frequency bands from several hundred GHz to the terahertz band, and each of the electromagnetic-wave absorption bands has a wide bandwidth.

### Means for Solving Problem

In order to solve the above-described problems, an electromagnetic-wave absorbing sheet disclosed in the present application includes: a first dielectric layer, a resistive layer, a second dielectric layer, and a reflective layer that are sequentially laminated from an electromagnetic-wave incident side, in which when a permittivity of the first dielectric layer is ε1 and a thickness of the first dielectric layer is D1, and a permittivity of the second dielectric layer is ε2 and a thickness of the second dielectric layer is D2, the following (Equation 1) and (Equation 2) are satisfied with respect to a center wavelength λ of electromagnetic waves $D 1 = 5 λ / 4 √ ε 1 \pm 20 %$ $D 2 = 5 λ / 4 √ ε 2 \pm 20 %$

### Effects of the Invention

The electromagnetic-wave absorbing sheet disclosed in the present application includes an electromagnetic-wave absorbing layer in which a first dielectric layer, a resistive layer, a second dielectric layer, and a reflective layer are sequentially laminated, thereby combining cancellation effects in which electromagnetic waves of a predetermined frequency are absorbed due to interference between electromagnetic waves reflected by the surface of the first dielectric layer, electromagnetic waves that are transmitted through the first dielectric layer and are reflected by the resistive layer, and electromagnetic waves that are transmitted through the resistive layer and the second dielectric layer and are reflected by the reflective layer. As a result, it is possible to realize an electromagnetic-wave absorbing sheet having wide absorption bands in a plurality of frequency bands.

### Brief Description of Drawings

[FIG. 1] FIG. 1 is a cross-sectional view illustrating a configuration of an electromagnetic-wave absorbing sheet according to the present embodiment.
[FIG. 2] FIG. 2 is a diagram showing electromagnetic-wave absorbing properties of the electromagnetic-wave absorbing sheet according to the present embodiment.
[FIG. 3] FIG. 3 is a diagram showing electromagnetic-wave absorbing properties of an electromagnetic-wave absorbing sheet of a comparative example.

### Description of the Invention

An electromagnetic-wave absorbing sheet disclosed in the present application includes: a first dielectric layer, a resistive layer, a second dielectric layer, and a reflective layer that are sequentially laminated from an electromagnetic-wave incident side, in which when a permittivity of the first dielectric layer is ε1 and a thickness of the first dielectric layer is D1, and a permittivity of the second dielectric layer is ε2 and a thickness of the second dielectric layer is D2, the following (Equation 1) and (Equation 2) are satisfied with respect to a center wavelength λ of electromagnetic waves $D 1 = 5 λ / 4 √ ε 1 \pm 20 %$ $D 2 = 5 λ / 4 √ ε 2 \pm 20 %$

With this configuration, some of the electromagnetic waves are reflected by the surface of the first dielectric layer, the remaining electromagnetic waves are transmitted through the first dielectric layer, and then some of the electromagnetic waves are reflected by the resistive layer, and the remaining electromagnetic waves are transmitted through the second dielectric layer and reach the reflective layer where they are reflected. The resulting electromagnetic waves reflected by the surface of the first dielectric layer, the electromagnetic waves transmitted through the first dielectric layer and reflected by the resistive layer, and the electromagnetic waves transmitted through the resistive layer and the second dielectric layer and reflected by the reflective layer interfere with each other, resulting in an electromagnetic-wave absorbing sheet with absorption bands spanning a plurality of wide frequency bands.

In the electromagnetic-wave absorbing sheet, it is preferable that a surface electric resistance of the resistive layer is 150 Ω/□ or more and 250 Ω/□ or less. In this way, it is possible to realize an electromagnetic-wave absorbing sheet in which electromagnetic waves in the 300 GHz frequency band are targeted for absorption.

Also, it is preferred that the first dielectric layer, the second dielectric layer, and the reflective layer all have light transmittance, and the resistive layer is a transparent layer containing at least one of a conductive oxide material and a conductive polymer. In this way, the electromagnetic-wave absorbing sheet as a whole can have light transmittance.

Furthermore, it is preferable that the resistive layer has a thickness of 0.01 µm or more and 10 µm or less. This reduces the influence of the thickness of the resistive layer on the electromagnetic-wave absorbing properties.

Also, it is preferred that the reflective layer has a surface electric resistance of 30 Ω/□ or less. In this way, the electromagnetic waves transmitted through the second dielectric layer can be reliably reflected, and the electromagnetic-wave absorbing properties resulting from interference with the incident electromagnetic waves can be improved.

Furthermore, it is preferable that the first dielectric layer and the second dielectric layer contain an acrylic resin, a silicone resin, or a urethane resin. This makes it possible to realize an electromagnetic-wave absorbing sheet that is easy to manufacture and has excellent durability.

Also, it is preferable that at least one of the first dielectric layer and the second dielectric layer is a laminate of a plurality of dielectric layers. This makes it possible to easily realize the laminated configuration of the first dielectric layer, the resistive layer, the second dielectric layer, and the reflective layer.

Hereinafter, the electromagnetic-wave absorbing sheet disclosed in the present application will be described with reference to the drawings.

### (Embodiment)

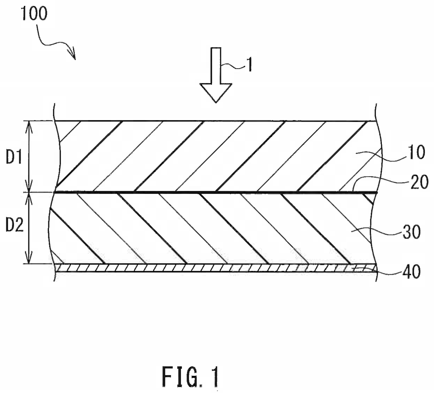

FIG. 1 is a cross-sectional view showing a configuration of an electromagnetic-wave absorbing sheet according to the present embodiment.

Note that FIG. 1 is a diagram that is drawn to facilitate understanding of the configuration of the electromagnetic-wave absorbing sheet according to this embodiment, and the sizes of the members shown in the drawing, particularly the thicknesses of the respective layers, are not necessarily depicted in accordance with reality.

### [Overall Configuration of Electromagnetic-Wave Absorbing Sheet]

An electromagnetic-wave absorbing sheet 100 illustrated in this embodiment is formed by sequentially laminating a first dielectric layer 10, a resistive layer 20, a second dielectric layer 30, and a reflective layer 40 from a side on which electromagnetic waves 1 to be absorbed are incident.

The electromagnetic-wave absorbing sheet 100 according to this embodiment is an electromagnetic-wave absorbing sheet 100 that uses the principle of electromagnetic-wave interference, in which electromagnetic waves incident on the electromagnetic-wave absorbing sheet are reflected by the surface of the first dielectric layer, the resistive layer, and the reflective layer, and the phase of incident waves incident on the electromagnetic-wave absorbing sheet and reflected waves reflected from the electromagnetic-wave absorbing sheet is inverted, whereby the reflected waves from the electromagnetic-wave absorbing sheet 100 appear to be absorbed.

### [Details of Each Member]

Next, each member constituting the electromagnetic-wave absorbing sheet 10 according to this embodiment will be described.

### <Dielectric Layers>

A first dielectric layer 10 and a second dielectric layer 30 of the electromagnetic-wave absorbing sheet according to this embodiment can both be formed from various dielectrics such as acrylic resin, silicone resin, urethane resin, titanium oxide, polyvinylidene fluoride, polyester resin, glass, and silicone rubber.

In particular, it is preferable to use acrylic resin, silicone resin, and urethane resin, which are readily available as sheets of a desired thickness and are excellent in durability, as the material for the dielectric layers.

Note that the first dielectric layer 10 and the second dielectric layer 30 can each be formed as a single layer configuration made of one type of material, or can be formed as two or more layers of the same or different materials laminated on top of each other. The first dielectric layer 10 and the second dielectric layer 30 can also be formed using the same dielectric material, or they can be formed using different dielectric materials, as well as different numbers of layers constituting the dielectric layers.

Thicknesses D1 and D2 of the first dielectric layer 10 and the second dielectric layer 30 are set in accordance with a wavelength λ, which is the reciprocal of the frequency of the electromagnetic waves 1 to be absorbed by the electromagnetic-wave absorbing sheet 100, such that the following conditional expressions (Equation 1) and (Equation 2) are satisfied, taking into account the permittivity ε (ε1, ε2) of the materials constituting the respective dielectric layers 10 and 30.

When the permittivity of the first dielectric layer 10 is ε1 and the thickness is D1, and the permittivity of the second dielectric layer 30 is ε2 and the thickness is D2, the following equations are obtained with respect to the central wavelength λ of the electromagnetic waves. $D 1 = 5 λ / 4 √ ε 1 \pm 20 %$ $D 2 = 5 λ / 4 √ ε 2 \pm 20 %$

Note that when the first dielectric layer 10 and/or the second dielectric layer 30 is a laminate of a plurality of dielectric layers, the thicknesses D1 and D2 of the laminate are set so as to satisfy (Equation 1) and (Equation 2) above, using overall permittivities ε1 and ε2 obtained by combining the plurality of dielectric layers constituting each dielectric layer.

In the electromagnetic-wave absorbing sheet according to this embodiment, by satisfying the conditions of (Equation 1) and (Equation 2) above, the phase between the reflected waves that are incident on the electromagnetic-wave absorbing sheet 100, are transmitted through the first dielectric layer 10, and are then reflected by the resistive layer 20, and the reflected waves that are not reflected by the resistive layer 20 but are transmitted therethrough, are further transmitted through the second dielectric layer 30, and are reflected by the reflective layer 40 can be adjusted with respect to the surface-reflected waves that are reflected on the surface of the electromagnetic-wave absorbing sheet 100, thereby realizing a reflection attenuation characteristic in which electromagnetic waves in a plurality of wide frequency bands in the electromagnetic waves reflected from the electromagnetic-wave absorbing sheet 100 are absorbed.

As an example, if the center frequency of the electromagnetic waves 1 absorbed by the electromagnetic-wave absorbing sheet 100 is set to 300 GHz (wavelength λ≈1) assuming the 300 GHz band, which is the frequency band used in next-generation information communication known as Beyond 5G, in order to obtain a multi-band electromagnetic-wave absorber with electromagnetic-wave absorption bands in the 300 GHz band and the 180 GHz and 60 GHz bands, which are frequencies equivalent to three-fifths and one-fifth of that, it is preferable to use a general dielectric material with a relative permittivity of about 2.5 for the first dielectric layer 10 and the second dielectric layer 30, and to set the thickness to 630 µm to 950 µm.

In the case of dielectric layers (10, 30) formed using a dielectric material with a relative permittivity of about 2.5, if the thickness is less than 630 µm or more than 950 µm, the center frequency of the electromagnetic waves to be absorbed will deviate to be higher or lower than 300 GHz, and at the same time, there will also be deviations in the frequencies of the 180 GHz band, which is three-fifths of that, and the 60 GHz band, which is one-fifth of that, making it impossible to obtain an electromagnetic-wave absorbing sheet 100 that absorbs electromagnetic waves in the desired frequency bands.

Note that although not shown in the drawings, in the electromagnetic-wave absorbing sheet 100 according to this embodiment, a polyethylene terephthalate (PET) sheet is used as a resin base when forming a later-described resistive layer 20, and the first dielectric layer 10 is formed by laminating this PET sheet serving as the resin base and an acrylic OCA (Optical Clear Adhesive).

By using an OCA having adhesive properties as the material for the first dielectric layer 10 in this way, a laminated structure of the resistive layer 20 and the first dielectric layer 10 can be easily formed. In addition, by configuring the first dielectric layer 10 as a two-layer structure composed of a PET sheet and an OCA, the material and thickness of the resin sheet used as a base (the PET sheet in the above example) can be selected from those preferred for forming the resistive layer 20. At the same time, by adjusting the permittivity and thickness of the other dielectric material sheet (the acrylic OCA sheet in the above example) used in combination therewith, an appropriate permittivity ε1 and thickness D1 can be obtained for the first dielectric layer 10. This makes it easy to form the resistive layer 20 while ensuring the electromagnetic-wave absorbing properties of the electromagnetic-wave absorbing sheet, thereby enabling realization of the electromagnetic-wave absorbing sheet 100 at low cost.

Note that in the electromagnetic-wave absorbing sheet 100 according to this embodiment, the second dielectric layer 30 is also made of an acrylic OCA (Optical Clear Adhesive) with emphasis on light transmittance and self-adhesive properties.

In this way, the resistive layer 20, the second dielectric layer 30, and the reflective layer 40 can be bonded together by the adhesive strength of the second dielectric layer 30, and therefore the structure of the electromagnetic-wave absorbing sheet 100 can be simplified, improving workability during manufacturing and enabling reduction of materials, thereby reducing the cost of producing the electromagnetic-wave absorbing sheet 100. Note that, as the OCA used for the first dielectric layer 10 and the second dielectric layer 30, silicone OCA, urethane OCA, and the like can also be suitably used in addition to the acrylic OCA described above.

Of course, an adhesive material such as a double-sided adhesive sheet can be used to bond the first dielectric layer 10, the resistive layer 20, the second dielectric layer 30, and the reflective layer 40, and an adhesive can be applied to the surfaces where the layers are bonded to form a laminate serving as the electromagnetic-wave absorbing sheet 100.

In addition, by using a transparent OCA as the first dielectric layer 10 and the second dielectric layer 30, and using a configuration in which light can be transmitted through the resistive layer 20 and the reflective layer 40, which will be described later, it is possible to realize an electromagnetic-wave absorbing sheet 100 that has light transmittance with a total light transmittance of a certain level or more as a whole.

The total light transmittance of the electromagnetic-wave absorbing sheet 100 is preferably 30% or more, and more preferably 40% or more. When the total light transmittance of the electromagnetic-wave absorbing sheet 100 is 30% or more, the opposite side of the electromagnetic-wave absorbing sheet 100 can be seen, and therefore, when used in an anechoic chamber or the like, measurement can be performed while checking an internal measuring device or the like, thereby ensuring practical light transmittance. In addition, when used in applications where design is required, or as an electromagnetic-wave absorbing sheet that covers a large surface area such as an entire window, the total light transmittance of the electromagnetic-wave absorbing sheet 100 is preferably 60% or more, and more preferably 70% or more.

### <Resistive Layer>

The resistive layer 20 of the electromagnetic-wave absorbing sheet 100 shown in this embodiment is disposed between the first dielectric layer 10 and the second dielectric layer 30, and serves to reflect some of the electromagnetic waves 1 that have been transmitted through the first dielectric layer 10, and transmit the remaining electromagnetic waves 1.

The percentage of the electromagnetic waves 1 reflected by the resistive layer 20 depends on the surface electric resistance of the resistive layer 20, in that the greater the difference between the surface electric resistance of the resistive layer 20 and the impedance of the OCA made of acrylic or the like and the PET, which are insulators that constitute the first dielectric layer 10 and the second dielectric layer 30, is, the greater the percentage of the electromagnetic waves 1 reflected by the resistive layer 20 is and the smaller the percentage of the electromagnetic waves 1 that are transmitted is. That is, since the impedance of the insulators is 10⁸ Ω or more, which is a very high value compared to the resistance assumed for the resistive layer 20, the lower the resistance of the resistive layer 20 is, the greater the percentage of the electromagnetic waves 1 that are reflected is.

In the electromagnetic-wave absorbing sheet 100 shown in the present embodiment, for example, when the center frequency of the electromagnetic waves 1 to be absorbed is targeted at 284 GHz, which is called the 300 GHz band, it is desirable that the surface electric resistance of the resistive layer 20 is 150 Ω/□ or more and 250 Ω/□ or less. Note that in this case, sub-electromagnetic-wave absorption bands are generated in the 50 to 80 GHz band, which is one-fifth of the target frequency, and in the 150 to 240 GHz band, which is three-fifths of the target frequency.

If the surface electric resistance of the resistive layer 20 is less than 150 Ω/□, the amount of electromagnetic waves reflected by the resistive layer 20 increases, while the amount of electromagnetic waves transmitted therethrough decreases. In addition, if the surface electric resistance of the resistive layer 20 is greater than 250 Ω/□,the amount of electromagnetic waves reflected by the resistive layer 20 decreases, and the amount of electromagnetic waves transmitted through the resistive layer 20 increases. As a result, the balance in interference between the electromagnetic waves reflected by the resistive layer 20 and the reflective layer 40 is lost, making it difficult to provide wide absorption bands in the three frequency bands. In the electromagnetic-wave absorbing sheet 100 of this embodiment, the surface electric resistance of the resistive layer 20 is designed to achieve an optimal balance between the electromagnetic waves 1 reflected by the resistive layer 20 and the electromagnetic waves 1 that are transmitted through the resistive layer 20 and reflected by the reflective layer 40. This allows the interference between the electromagnetic waves 1 that are surface-reflected at the surface of the first dielectric layer 10, the electromagnetic waves 1 that are reflected by the resistive layer 20, and the electromagnetic waves 1 that are transmitted through the resistive layer 20 and reflected by the reflective layer 40 to be appropriately combined, thereby enabling the electromagnetic waves 1 in wide frequency bands to be favorably absorbed in a plurality of bands. Therefore, it is important to set the value of the surface electric resistance of the resistive layer 20 to a value within a predetermined range that corresponds to the center frequency of the electromagnetic waves 1 to be absorbed.

In addition, if the target frequency absorbed by the electromagnetic-wave absorbing sheet 100 is different from the 300 GHz band described above, it is preferable to use the simulation described below to determine the surface electric resistance of the resistive layer 20 that will favorably absorb electromagnetic waves of the target frequency.

The material of the resistive layer 20 used in the electromagnetic-wave absorbing sheet 100 according to this embodiment is not particularly limited as long as it is a material that can achieve the surface electric resistance required for the resistive layer 20 that is set according to the absorption target frequency, such as a surface electric resistance of 150 Ω/□ or more and 250 Ω/□ as described above when, for example, the absorption target frequency is in the 300 GHz band. Specifically, conductive organic polymer films, sputtered films, vapor-deposited films, and the like can be used favorably. In addition, the above-mentioned conductive organic polymer films, sputtered films, and vapor-deposited films are preferable in that the surface electric resistance can be controlled by the film thickness and formation density, and therefore a resistive layer 20 having a desired surface electric resistance can be easily formed.

In the electromagnetic-wave absorbing sheet 100 shown in this embodiment, if the resistive layer 20 is thick, the electromagnetic waves 1 transmitted through the resistive layer 20 will be attenuated, and therefore the resistive layer 20 is preferably a thin film. In addition, even if the electromagnetic-wave absorbing sheet 100 as a whole has light transmittance, a thick resistive layer 20 is undesirable because it reduces the transmittance of light. From the above viewpoint, it is preferable that the resistive layer 20 is on a thin film that is as thin as possible so long as it can realize a predetermined surface electric resistance, and specifically, it is preferable that it is 0.01 µm to 10 µm thick.

The conductive organic polymer used as the resistive layer 20 is a conjugated conductive organic polymer, and it is preferable to use polythiophene or a derivative thereof, or polypyrrole or a derivative thereof.

In addition, an organic polymer in which the main chain is constituted by a π-conjugated system can be used as the resistive layer 20, and a polyacene-based conductive polymer, a polyphenylene-based conductive polymer, a polyphenylene vinylene-based conductive polymer, a polyaniline-based conductive polymer, a polyacetylene-based conductive polymer, a polythiophene vinylene-based conductive polymer, copolymers thereof, and the like can be used as the resistive layer 20.

Note that polyanions can be used as counter anions in the conductive organic polymer used in the resistive layer 20. Although there is no particular limitation on the polyanions, it is preferable that an anion group that can cause chemical oxidation doping to occur is included in a conjugate conductive organic polymer. Examples of this kind of anion group include groups represented by the general formulas -O⁻SO₃X, -O-PO(OX)₂, -COOX, -SO₃X, and the like (in the formulas, X indicates a hydrogen atom or an alkali metal atom), and among these, the groups indicated by -SO₃X and -O-SO₃X are particularly preferable since they have an excellent dope effect on conjugate conductive organic polymers.

The above-described conductive organic polymers may be used alone, or in combination of two or more. Among the materials described as examples above, a polymer composed of one or two types selected from polypyrrole, poly(3-methoxythiophene), poly(3,4-ethylenedioxythiophene), poly(2-anilinesulfonic acid), and poly(3-anilinesulfonic acid) is preferable since they have higher light transmittance and conductivity.

In particular, poly(3,4-ethylenedioxythiophene: PEDOT) and polystyrene sulfonic acid (PSS) can be used as the combination of the conjugated conductive organic polymer and the polyanion.

Also, in the resistive layer 20 of the electromagnetic-wave absorbing sheet 100 according to the present embodiment, a dopant can be used in combination to obtain a predetermined resistance by controlling the electric conductivity of the conductive organic polymer. Halogens such as iodine and chlorine, Lewis acids such as BF₃ and PF₅, proton acids such as nitric acid and sulfuric acid, transition metals, alkali metals, amino acids, nucleic acids, surfactants, pigments, chloranil, tetracyanoethylene, TCNQ, and the like can be used as the dopant.

The content of the conductive organic polymer in the resistive layer 20 is preferably 10 mass% or more and 35 mass% or less with respect to the total mass of the solid content included in the composition of the resistive layer 20. If the content falls below 10 mass%, the conductivity of the resistive layer 20 tends to decrease. For this reason, as a result of the surface electric resistance of the resistive layer 20 being set to a predetermined range in order to achieve impedance matching, the electromagnetic-wave absorbing sheet tends to become thicker overall and, when light transmittance is included, the optical properties tend to deteriorate due to the film thickness of the resistive layer 20 increasing. On the other hand, if the content exceeds 35 mass%, the coating suitability at the time of coating the resistive layer 20 decreases due to the structure of the conductive organic polymer, and it tends to be difficult to form a favorable resistive layer 20, and when the electromagnetic-wave absorbing sheet 100 has light transmittance overall, haze of the resistive layer 20 tends to increase, and the optical properties tend to deteriorate.

The resistive layer 20 may also be configured to contain a carbon material such as a carbon microcoil, a carbon nanotube, or graphene.

A carbon microcoil is a type of vapor-grown carbon fiber obtained primarily through catalytically activated pyrolysis of acetylene, and is a material with a 3D helical/spiral structure with a coil diameter on the order of microns. It is preferable that the coil diameter is 1 to 10 µm, the diameter of the carbon fiber forming the coil is 0.1 to 1 µm, and the coil length is 1 to 10 mm.

Specifically, for example, carbon nanotubes can be obtained through vapor-phase growth methods such as arc discharge, laser evaporation, and thermal decomposition. The carbon nanotubes used as the resistive layer 20 of the electromagnetic-wave absorbing sheet 100 according to this embodiment may be either single-walled or multi-walled.

Graphene can be obtained through, for example, a peel-and-transfer method, a SiC thermal decomposition method, a chemical vapor deposition method, a method of cutting carbon nanotubes, or the like. As the graphene used as the resistive layer 20 of the electromagnetic-wave absorbing sheet 100 according to this embodiment, it is preferable to use powdered graphene in a scale shape, from the viewpoint of easily obtaining a desired aspect ratio and the viewpoint of orientation in the electromagnetic-wave absorbing sheet 10.

Note that the resin in which the above-described carbon material is dispersed may be a water-soluble polyester resin. This makes it possible to improve the weather resistance of the resistive layer 20 and to realize a highly reliable electromagnetic-wave absorbing sheet 100 with a stable surface electric resistance.

Note that the resistive layer 20 can be formed by coating a resin base with a coating composition serving as a coating material for forming the resistive layer 20 and drying the resulting composition as described above.

A coating method such as bar-coating, reverse coating, gravure coating, micro-gravure coating, die-coating, dipping, spin-coating, slit-coating, and spray-coating can be used as the method for coating the base with the coating material for forming the resistive layer. The drying performed after the coating is preferably performed for 5 to 60 minutes at 100 to 150°C, as long as the solvent component of the coating material for forming the resistive layer evaporates. Also, the resistive layer 20 may be formed by emitting UV light (ultraviolet rays) or an EB (electron beam) to the coating film to cure the coating film.

Note that the base used to form the resistive layer 20 is not particularly limited, but when an electromagnetic-wave absorbing sheet having visible light transmittance is to be formed, a transparent base having transparency is preferred. Such a transparent base can be made of various materials such as resin, rubber, glass, or ceramic, and as described above, the electromagnetic-wave absorbing sheet 100 illustrated in this embodiment uses a PET film with a thickness of 50 µm.

### <Reflective Layer>

The reflective layer 40 is a layer that reflects the electromagnetic waves 1 transmitted through the second dielectric layer 30. Unlike the resistive layer 20, the reflective layer 40 does not need to transmit the electromagnetic waves 1. For this reason, it is preferable that the surface electric resistance is as low as possible, and it is most preferable that the surface electric resistance is 0 Ω/□,but when manufacturing is taken into consideration, the lower limit that can be realized is thought to be about 0.01 Ω/□. The upper limit of the surface electric resistance of the reflective layer 40 is preferably 30 Ω/□. If the surface electric resistance of the reflective layer 40 is higher than 30 Q/o, it becomes difficult to obtain high selective electromagnetic-wave absorbing properties for electromagnetic waves of a desired frequency. As such a reflective layer 40, a metal foil or a metal plate can be favorably used.

In order to make the electric-wave absorbing sheet 10 flexible, the material for the reflective layer 40 can be a metal foil or a film coated with a conductive metal paste made of silver, copper, or the like. Among these, a metal foil is more preferable because of its low surface electric resistance, and various metal foils such as copper foil, aluminum foil, and gold foil can be used. Among these, it is particularly preferable to use aluminum foil as the reflective layer 40, taking into consideration the cost and the effect of oxidation in air. The metal foil such as aluminum foil that forms the reflective layer 40 can be easily realized by rolling a metal material. In addition, when forming the reflective layer 40 from a vapor-deposited film in which a metal is vapor-deposited on the surface of a non-metallic material, it is preferable to appropriately select a vapor deposition method that has conventionally been used to form various types of vapor deposition films, taking into consideration the heat resistance temperature and the like of the metal material to be vapor-deposited and the non-metallic material such as resin that serves as the base.

The thickness of the reflective layer 40 is not particularly limited, but when a metal foil is used to form a flexible electric-wave absorbing sheet 100, if the reflective layer 40 is too thick, it will be meaningless in terms of the electromagnetic-wave absorbing properties and will result in wasted material, and if the reflective layer 40 is too thin, it may not be strong enough, causing problems such as tearing during production or use. Therefore, a thickness of 1 µm to 20 µm is preferable. In the case of a film coated with a metal paste, it is sufficient that a base such as PET is coated at a thickness at which it is possible to maintain a sufficiently low resistance value, and generally a thickness of about 0.01 µm to 10 µm is sufficient.

In addition, in the electric-wave absorbing sheet 100 according to this embodiment shown in FIG. 1, by forming a vapor-deposited film of a metal material directly on the surface of the second dielectric layer 30 opposite to the side on which the resistive layer 20 is formed, the reflective layer 40 can also be formed using only a vapor-deposited film of a conductive material such as a metal. When a metal vapor-deposited film is formed on the back side of the second dielectric layer 30, no gap occurs between the second dielectric layer 30 and the reflective layer 40 compared to when the second dielectric layer 30 and the reflective layer 40 are formed separately and then arranged in close contact with each other. For this reason, the electromagnetic waves 1 that are transmitted through the second dielectric layer 30 can be reflected at the position of the rear surface of the second dielectric layer 30, making it easy to realize an electric-wave absorbing sheet 100 that has the frequency characteristic of the desired electric-wave absorption amount.

On the other hand, when a vapor-deposited film is used for the reflective layer 14, the density of the conductive material in the vapor-deposited film needs to be uniform and sufficient, compared to when a metal foil is used. According to studies conducted by the inventors, it is preferable to make the surface electric resistance of the reflective layer 30 Ω/□ or less, and it is preferable to sufficiently control the thickness of the metal vapor-deposited film to set the surface electric resistance to a desired value or less.

In addition, in order to provide the electric-wave absorbing sheet 100 with flexibility and light transmittance, a conductive mesh made of conductive fibers can be used as the reflective layer 40. The conductive mesh can be formed, for example, by attaching a metal to a mesh woven from polyester monofilament to make it conductive. As the metal, copper, silver, or the like having high conductivity can be used. In addition, products have been produced that have a black anti-reflection layer provided on the outside of the metal film covering the surface of the conductive mesh to reduce reflection from the metal film.

Alternatively, the reflective layer 40 can be a conductive metal grid or a metal mesh in which thin metal wires, such as copper wires, having a diameter of several tens to several hundreds of µm are arranged vertically and horizontally.

Note that when the reflective layer 40 is formed using the above-mentioned conductive mesh or conductive metal grid, in order to ensure flexibility and light transmittance, it is formed to have the minimum thickness possible as long as the surface electric resistance required for the reflective layer 40 can be realized.

The aperture ratio of the reflective layer 40 formed as a conductive mesh or conductive grid is preferably larger from the viewpoint of ensuring light transmittance, and is preferably smaller from the viewpoint of reliably reflecting electromagnetic waves on its surface as the reflective layer 40 and enhancing the electromagnetic-wave absorbing properties of the electromagnetic-wave absorbing sheet 100. According to the study conducted by the inventors, the aperture ratio is preferably 35% or more and 85% or less, and more preferably 35% or more and 75% or less.

Note that even when a conductive mesh or conductive grid is used as the reflective layer 40, the surface electric resistance of the reflective layer 40 is preferably 30 Ω/□ or less.

### <Adhesive Layer>

Although not shown in FIG. 1, an adhesive layer can be formed on the back surface of the reflective layer 40 such that the electromagnetic-wave absorbing sheet 100 according to the present embodiment can be easily placed at a predetermined position.

A known material used as an adhesive layer, such as adhesive tape, an acrylic-based adhesive, a rubber-based adhesive, a silicone-based adhesive, or the like can be used as the adhesive layer 4. A tackifier or a cross-linking agent can also be used to adjust the tackiness to the adherend, and to reduce adhesive residue. The tackiness to the adherend is preferably 5 N/10 mm to 12 N/10 mm. If the tackiness is smaller than 5 N/10 mm, the electromagnetic-wave absorbing sheet 100 will easily peel off of the adherend or shift in some cases. Also, if the tackiness is greater than 12 N/10 mm, the electromagnetic-wave absorbing sheet 100 will be more difficult to peel off of the adherend.

The thickness of the adhesive layer 4 is preferably 20 µm to 100 µm. If the thickness of the adhesive layer 4 is less than 20 µm, the tackiness will decrease, and the electromagnetic-wave absorbing sheet 100 will easily peel off of the adherend or shift in some cases. If the thickness of the adhesive layer 4 is greater than 100 µm, the electromagnetic-wave absorbing sheet 100 will be more difficult to peel off of the adherend. If the cohesive force of the adhesive layer is small, adhesive residue will appear on the adherend in some cases when the electromagnetic-wave absorbing sheet 100 is peeled off. Also, a small cohesive force is a factor contributing to a decrease in the overall flexibility of the electromagnetic-wave absorbing sheet 100.

Note that an adhesive layer 4 that adheres the electromagnetic-wave absorbing sheet 100 to the adherend such that it cannot be peeled off can be used as the adhesive layer 4 that can be used in the electromagnetic-wave absorbing sheet 100 according to the present embodiment, and an adhesive layer 4 that performs peelable adhesion can also be used thereas. Note that in the electromagnetic-wave absorbing sheet 100 according to the present embodiment, the configuration including the adhesive layer 4 is not an essential element, but the electromagnetic-wave absorbing sheet 100 can be adhered to a desired member using various types of conventionally common adhesion methods.

### <Protective Layer>

In addition, a protective layer for protecting the surface of the electromagnetic-wave absorbing sheet 100 can also be arranged on the side of the first dielectric layer 10 on which the electromagnetic waves 1 are incident.

The protective layer is a film that protects the first dielectric layer 10 from being damaged by external forces and from changes in the relative permittivity ε1 due to the influence of ultraviolet rays and moisture. Note that the protective layer is not an essential component of the electromagnetic-wave absorbing sheet 100 according to this embodiment, and depending on the material of the first dielectric layer 10 and the circumstances under which the electromagnetic-wave absorbing sheet 100 is used, if there is little concern that the permittivity ε1 of the first dielectric layer 10 will change or the surface will be damaged due to moisture adhering to the surface, it is possible to select a configuration of the electromagnetic-wave absorbing sheet 100 without a protective layer.

The protective layer can be made of a resin material such as polyethylene terephthalate. Note that although the resin material used as the protective layer has a certain resistance value, by setting the thickness of the protective layer to be thin, the effect of the presence or absence of the protective layer on the electromagnetic waves 1 incident on the electromagnetic-wave absorbing sheet 100 can be reduced to a level that is not problematic in practical use.

### (Working Examples)

The results of a study on the frequency characteristics of electromagnetic-wave absorption of the electromagnetic-wave absorbing sheet according to the present embodiment will be described below.

Note that in the following study, simulations were performed using full-wave three-dimensional electromagnetic field software "Ansys HFSS (product name: manufactured by ANSYS, Inc.)" that uses the finite element method.

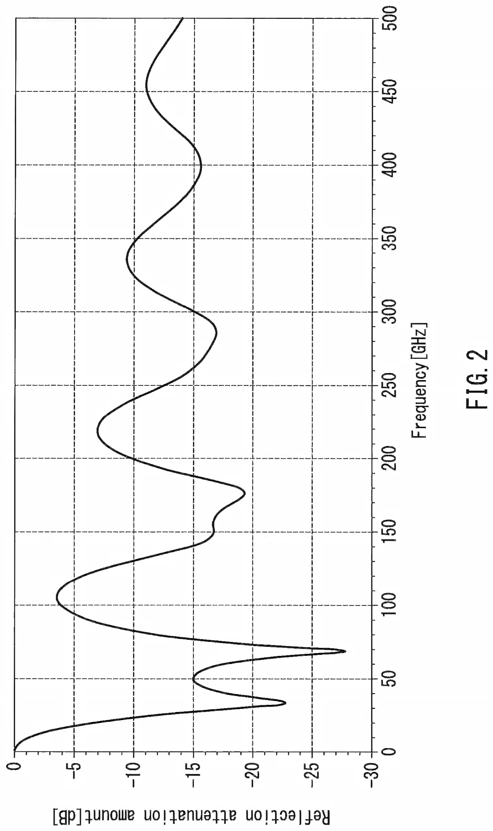

FIG. 2 is a diagram showing change in a reflection attenuation amount with respect to the frequency of incident electromagnetic waves, as the electromagnetic-wave absorbing properties of an electromagnetic-wave absorbing sheet of a working example according to this embodiment.

Here, the reflection attenuation amount is the strength (energy) of electromagnetic waves reflected by the electromagnetic-wave absorbing sheet relative to the strength (energy) of electric field waves resulting from electromagnetic-wave incidence, expressed in dB. For this reason, when the reflection attenuation amount is -10 dB, the strength of the reflected electromagnetic waves is 1/10 (10%) of the incident electromagnetic waves, which indicates that 90% of the energy of the electromagnetic waves is absorbed by the electromagnetic-wave absorbing sheet.

The first electromagnetic-wave absorbing sheet whose electromagnetic-wave absorbing properties are shown in FIG. 2 is assumed to have incident electromagnetic waves 1 with a frequency of approximately 300 GHz (center wavelength λ=1 mm) and to use an acrylic OCA with a permittivity ε (ε1=ε2) of 2.5 for both the first dielectric layer 10 and the second dielectric layer 20. Thicknesses D1 and D2 of the dielectric layers are each 791 µm according to (Equation 1) and (Equation 2), are within a range of ±20%, and range from 632 µm to 949 µm. In this working example, taking into consideration the actual production of an electromagnetic-wave absorbing sheet, the thickness of the available acrylic OCA was set to D1=D2=850 µm within the range of 632 µm to 949 µm.

The resistive layer 20 is assumed to be made of PEDOT, which is a conductive organic polymer, and the resistive layer 20 is optimized to realize favorable electromagnetic-wave absorbing properties with an electromagnetic-wave attenuation amount of -10 dB or more in the 300 GHz band, 180 GHz band, and 60 GHz, resulting in a surface electric resistance of 189 Ω/□.

Assuming that the reflective layer 40 is made of aluminum foil, the surface electric resistance was set to 0 Ω/□.

The frequency characteristic of the reflection attenuation amount of the first electromagnetic-wave absorbing sheet of the working example shown in FIG. 2 confirmed that the electromagnetic-wave absorbing sheet has absorption bands at which electromagnetic waves are absorbed over a wide range in three frequency bands, namely, a first frequency band (23 to 83 GHz) centered at a frequency of 60 GHz, a second frequency band (130 to 200 GHz) centered at 180 GHz, and a third frequency band (240 to 325 GHz) formed as a higher frequency band including 300 GHz.

Next, as a comparative example, electromagnetic-wave absorbing properties were measured for an electromagnetic-wave absorbing sheet in which the laminate structure of the first dielectric layer, the resistive layer, the second dielectric layer, and the reflective layer was not changed, but the thickness D1 of the first dielectric layer and the thickness D2 of the second dielectric layer were set to values that did not satisfy the conditions of (Equation 1) and (Equation 2) described above.

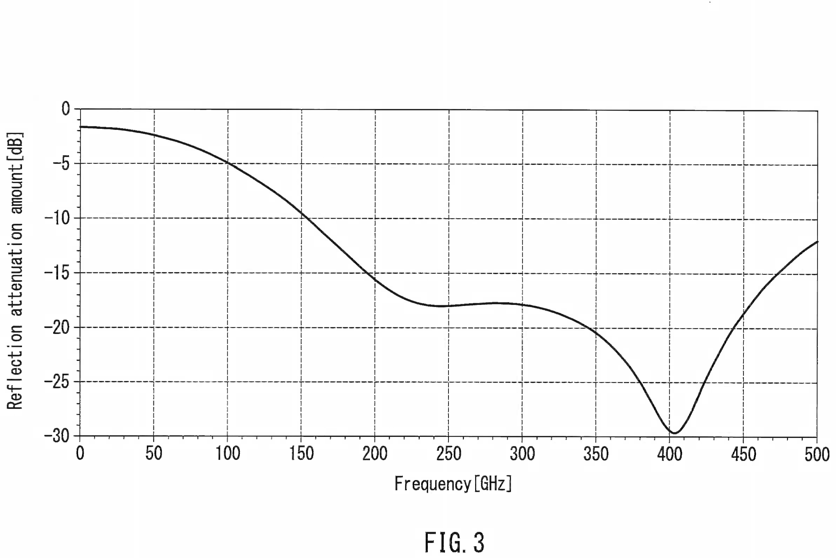

FIG. 3 is a diagram showing the frequency characteristic of the reflection attenuation amount of the second electromagnetic-wave absorbing sheet, which is a comparative example.

In the second electromagnetic-wave absorbing sheet, which is a comparative example, the thickness D1 of the first dielectric layer and the thickness D2 of the second dielectric layer are both set to "λ/4", which is the thickness of the dielectric layer used in a general electromagnetic-wave interference-type electromagnetic-wave absorber. Specifically, it was assumed that the frequency of the incident electromagnetic waves 1 was approximately 300 GHz (center wavelength λ=1 mm), which is the same as in the case of the first electromagnetic-wave absorbing sheet described above, and that the first dielectric layer and the second dielectric layer were both made of acrylic OCA with a permittivity ε (ε1=ε2) of 2.5. Note that the thickness of each dielectric layer was set to 150 µm (D1=D2=150 µm).

The surface electric resistance of the resistive layer was set to 189 Ω/□,which is the same as the first electromagnetic-wave absorbing sheet described above, and the surface electric resistance of the reflective layer 40 was set to 20 Ω/□, assuming a state in which silver paste is applied to a PET base.

The frequency characteristic of the reflection attenuation amount of the second electromagnetic-wave absorbing sheet shown in FIG. 3 differs from the frequency characteristic of the first electromagnetic-wave absorbing sheet according to the present embodiment, and although a reflection attenuation amount of -10 dB or more, which corresponds to 90% absorption, is obtained in the frequency band of 155 GHz or higher, an electromagnetic-wave absorbing sheet with a plurality of absorption bands like the first electromagnetic-wave absorbing sheet was not obtained.

As described above, in the electromagnetic-wave absorbing sheet according to the present embodiment, in order to realize an electromagnetic-wave absorbing sheet that has absorption bands in a plurality of wide frequency bands, it was confirmed that when the permittivity of the first dielectric layer is ε1 and the permittivity of the second dielectric layer 30 is ε2, the thickness D1 of the first dielectric layer and the thickness D2 of the second dielectric layer must satisfy the following conditional expressions with respect to the center wavelength λ of the electromagnetic waves: $D 1 = 5 λ / 4 √ ε 1 \pm 20 %$ $D 2 = 5 λ / 4 √ ε 2 \pm 20 %$

Note that in the above-described embodiment, the center frequency of the electromagnetic waves incident on the electromagnetic-wave absorbing sheet is 300 GHz. However, if the center frequency is in a higher frequency band, for example, 1 THz (terahertz), the thicknesses D1 and D2 of the first dielectric layer and the second dielectric layer will be smaller, and if a resin material with a normal permittivity of around 2.5 is used, a thinner resin sheet will be required. However, for example, at 1 THz, the center wavelength λ will be about one-third, and therefore it can be understood that this is within a sufficiently practical range.

### Industrial Applicability

The electromagnetic-wave absorbing sheet disclosed in the present application has a configuration in which a first dielectric layer, a resistive layer, a second dielectric layer, and a reflective layer are sequentially laminated, thereby making it possible to realize an electromagnetic-wave absorbing sheet with favorable absorption properties for electromagnetic waves in a plurality of wide frequency bands.

### Description of Reference Numerals

- 1: (Incident) electromagnetic waves
- 10: First dielectric layer
- 20: Resistive layer
- .30: Second dielectric layer
- 40: Reflective layer
- 100: Electromagnetic-wave absorbing sheet

## Claims

1. An electromagnetic-wave absorbing sheet comprising:
a first dielectric layer, a resistive layer, a second dielectric layer, and a reflective layer that are sequentially laminated from an electromagnetic-wave incident side,
wherein when a permittivity of the first dielectric layer is ε1 and a thickness of the first dielectric layer is D1, and a permittivity of the second dielectric layer is ε2 and a thickness of the second dielectric layer is D2, the following (Equation 1) and (Equation 2) are satisfied with respect to a center wavelength λ of electromagnetic waves. $D 1 = 5 λ / 4 √ ε 1 \pm 20 %$ $D 2 = 5 λ / 4 √ ε 2 \pm 20 %$

2. The electromagnetic-wave absorbing sheet according to claim 1,
wherein a surface electric resistance of the resistive layer is 150 Ω/□ or more and 250 Ω/□ or less.

3. The electromagnetic-wave absorbing sheet according to claim 1 or 2,
wherein the first dielectric layer, the second dielectric layer, and the reflective layer all have light transmittance, and
the resistive layer is a transparent layer containing at least one of a conductive oxide material and a conductive polymer.

4. The electromagnetic-wave absorbing sheet according to any one of claims 1 to 3,
wherein the resistive layer has a thickness of 0.01 µm or more and 10 µm or less.

5. The electromagnetic-wave absorbing sheet according to any one of claims 1 to 4,
wherein the reflective layer has a surface electric resistance of 30 Ω/□ or less.

6. The electromagnetic-wave absorbing sheet according to any one of claims 1 to 5,
wherein the first dielectric layer and the second dielectric layer contain an acrylic resin, a silicone resin, or a urethane resin.

7. The electromagnetic-wave absorbing sheet according to any one of claims 1 to 6,
wherein at least one of the first dielectric layer and the second dielectric layer is a laminate of a plurality of dielectric layers.
